## Europäisches Patentamt

(19) **European Patent Office**

**Office européen des brevets**

(11) Veröffentlichungsnummer: **0 027 883**
**B1**

(12) **EUROPÄISCHE PATENTSCHRIFT**

(45) Veröffentlichungstag der Patentschrift:
06.06.84

(51) Int. Cl.³: **G 11 C 11/40, H 01 L 27/02**

(21) Anmeldenummer: **80105494.1**

(22) Anmeldetag: **15.09.80**

(54) Speicherzellennachbildung zur Referenzspannungserzeugung für Halbleiterspeicher in MTL-Technik.

(30) Priorität: **29.10.79 DE 2943565**

(43) Veröffentlichungstag der Anmeldung:
**06.05.81 Patentblatt 81/18**

(45) Bekanntmachung des Hinweises auf die Patenterteilung:
**06.06.84 Patentblatt 84/23**

(84) Benannte Vertragsstaaten:
**DE FR GB IT NL SE**

(56) Entgegenhaltungen:
**DE - B - 2 738 187**
**US - A - 4 057 789**
**US - A - 4 075 609**
**US - A - 4 122 548**

**IEEE JOURNAL OF SOLID STATE CIRCUITS, Band SC-10, Nr. 5, Oktober 1975, New York, US, R. MÜLLER: "Current hogging injection logic. A new logic with high functional density", Seiten 348-352**
**IEEE JOURNAL OF SOLID STATE CIRCUITS, Band SC-8, Nr. 5, Oktober 1973, New York, US, S.K. WIEDMANN: "Injection-coupled memory: a high-density static bipolar memory", Seiten 332-337**

(73) Patentinhaber. **International Business Machines Corporation, Old Orchard Road, Armonk, N.Y. 10504 (US)**

(72) Erfinder: **Heuber, Klaus, Taunusstrasse 62, D-7030 Böblingen (DE)**
Erfinder: **Klink, Erich, Max-Eyth-Strasse 34, D-7036 Schönaich (DE)**
Erfinder: **Rudolph, Volker, Dr., Finkenweg 20, D-7031 Aidlingen-Dachtel (DE)**
Erfinder: **Wiedmann, Siegfried, Dr., Im Himmel 64A, D-7000 Stuttgart 80 (DE)**

(74) Vertreter: **Rudolph, Wolfgang, Schönaicher Strasse 220, D-7030 Böblingen (DE)**

## Beschreibung

Die Erfindung betrifft eine Speicherzellennachbildung nach dem Oberbegriff des Patentanspruchs 1.

In der DE-PS 2 657 561 ist eine Nachladeschaltung für ein Halbleiterspeicher mit Speicherzellen aus bipolaren Transistoren bekanntgeworden, die dadurch charakterisiert ist, daß eine Ruhezustands-Referenzschaltung über eine Nachladesteuerleitung von einem getakteten Signal gesteuert wird, daß mit der Ruhezustands-Referenzschaltung eine Fehlerfall-Referenzschaltung verbunden ist und daß beide über eine Referenzleitung mit den Nachladeschaltungen verbunden sind, daß die Pegel der Spannungen auf den Bitleitungen im Ruhezustand durch den Strom bestimmt werden, der durch zwei Stromquellen fließt, die mit den Bitleitungen und den als Schottky-Dioden ausgeführten Entkoppeldioden direkt verbunden sind, wobei letztere ein gemeinsamer Kathodenanschluß mit der Referenzleitung verbindet.

Hier ist bereits eine Nachlade-Referenzschaltung für den Ruhezustand und eine für den Fehlerfall angegeben. Diese Schaltung hat den Nachteil, daß sie nicht für integrierte Speicher mit MTL-Speicherzellen verwendet werden kann, da bei derartigen Speichern ein zusätzliches Problem auftritt, wie nachfolgend beschrieben wird.

Zum Auslesen der in einer MTL-Speicherzelle gespeicherten Information wird deren Wortleitungspotential um einige 100 mV abgesenkt und gleichzeitig wird durch jede der beiden vorhandenen Bitleitungen ein Lesestrom zugeführt. Da die Emitter-Basisspannungen der vorhandenen PNP-Transistoren aller unselektierten Speicherzellen um ca. 0,5 V kleiner sind als die Emitter-Basisspannung der selektierten Speicherzelle, fließt praktisch der gesamte Lesestrom in die selektierte Speicherzelle. Dadurch wird im wesentlichen bewirkt, daß die Emitter-Basisspannung des einen Zell-PNP-Transistors höher ist als die des anderen. Die Spannungsdifferenz wird im Lese-/Schreibverstärker angezeigt. Haben nun n nicht selektierte Zellen eine 0 gespeichert, dann fließt trotz des praktisch abgeschalteten Injektorstroms ein Rückinjektionsstrom IR ungefähr $1/2 \cdot IO \cdot n$, wobei IO der Ruheinjektionsstrom der Speicherzelle ist. Aufgrund der hohen Speicherkapazität klingt dieser Rückinjektionsstrom nur langsam ab. Damit dieser parasitäre Lesestrom keinen großen Einfluß auf den Lesevorgang hat, muß der Lesestrom der selektierten Zelle groß gegenüber dem parasitären Rückinjektionsstrom der unselektierten Zellen sein. Aus diesem Grunde muß der Ruhestrom der Speicherzelle auf einen sehr kleinen Wert gehalten werden, der z. B. bei derzeit verwendeter Technik ungefähr zwischen 10 und 100 nA liegt. Daraus ergibt sich zwar eine sehr kleine Speicherruheleistung, jedoch geben sich daraus große Schwierigkeiten für die Nachladeoperation. Denn um einerseits zu gewährleisten, daß die nicht selektierten Zellen bei einer Dauerselektion des Speicherchips genügend Strom erhalten, um die gespeicherten Informationen zu halten und andererseits zu kontrollieren, daß der Ruhestrom nicht den Lesevorgang stört, müßte eine extrem genaue Bitleitungs-Nachladeoperation ausgeführt werden. Eine Übersteuerung, wie sonst üblich ist hier nicht möglich. Es wurde deshalb in der Europäischen Patentanmeldung 80 103 389.5 bereits vorgeschlagen, eine Nachladeschaltung über einen integrierten Halbleiterspeicher, dessen Speicherzellen aus bipolaren Transistoren mit PNP-Lastelementen bestehen, die in Kreuzungspunkten von Wortleitungen und Bitleitungspaaren liegen, die über Bit- und/oder Wortreferenzleitungen sowie Bitnachlade- und/oder Wort-Nachlade-Schalter die erforderlichen Spannungen zur Aufrechterhaltung der gespeicherten Information liefert, zu schaffen, die dadurch charakterisiert ist, daß mit der Bitreferenzleitung und der Wortreferenzleitung ein als Spannungsquelle mit sehr kleinem Innenwiderstand dienender Impedanzwandler verbunden ist, dessen Ausgangsspannung von einer Gruppe vorgeschalteter Referenzspeicherzellen geregelt ist.

Da die Referenzspeicherzellen mit den eigentlichen Informationsspeicherzellen auf einem Chip integriert sind und bis zu 20% der eigentlichen Informationsspeicherzellen betragen können, ist der Platzverlust auf einem Speicherchip durch derartige Referenzspeicherzellen relativ groß.

Aus IEEE Journal of Solid State Circuits, Vol. SC/10, No. 5, Oct. 1975, Seiten 348 bis 352 ist eine Halbleiteranordnung bekanntgeworden, die es ermöglicht, ein in MTL-Technik aufgebautes Halbleiterchip so zu gestalten, daß n Gebiete von P-Diffusionen, die als Kollektor- oder Injektorstreifen ausgeführt sind, parallel zueinander innerhalb einer N-Wanne liegen. Durch diese Anordnung ist zwar ein raumsparender Effekt möglich, jedoch ist diese Anordnung weder für eine Speicherzellennachbildung verwendet worden, noch sind darin Anregungen in der Art und Weise enthalten, daß Referenzspeicherzellen keine Speichereigenschaften zu haben brauchen und in Randzonengebieten eines Chips untergebracht werden können.

Der Erfindung liegt deshalb die Aufgabe zugrunde, den für die Referenzspeicherzellen erforderlichen Platz auf dem Chip durch eine Speicherzellennachbildung, die alle kritischen Spannungs- und Stromkriterien erfüllt, jedoch zu einer Informationsspeicherung nicht geeignet zu sein braucht, wesentlich zu reduzieren.

Die erfindungsgemäße Lösung ergibt sich aus dem Kennzeichen des Patentanspruchs 1.

Weitere Ausgestaltungen ergeben sich aus den Kennzeichen der Patentansprüche 2 bis 4.

Die vorher aufgezeigten Nachteile der bisherigen Referenzspannungsspeicherzellen werden dadurch vermieden, das eine äquivalente Refe-

renzspannungsspeicherquelle geschaffen wird, die nur ca. $1/5$ der Fläche einer bisherigen Speicherzelle benötigt. Dieser wesentlichen Verringerung des Platzbedarfs lag der Gedanke zugrunde, daß die Referenzzellen eigentlich nicht zur Informationsspeicherung herangezogen werden, so daß eine äquivalente Schaltung zu schaffen ist, die zwar alle kritischen Spannungs- und Strombedingungen erfüllt, jedoch nicht zur Speicherung eines Bits ausgerüstet zu sein braucht. Dadurch ist es möglich, daß die Diffusionen in der Art zusammengelegt werden, daß die richtige Zellreferenzspannung abgegeben wird, jedoch keine eigentliche Informationsspeicherzelle entsteht. Ein weiterer Vorteil besteht darin, daß zwischen den eigentlichen Informationsspeicherzellen und den nachgebildeten Referenzspeicherzellen ein Temperatur- und Prozeßparametergleichlauf erzielt wird. Die geschaffene Nachbildung der Referenzspeicherzellen benötigt ca. $1/5$ der Fläche verglichen mit der erforderlichen Fläche für die bisherige Referenzspeicherzelle. Durch die Kleinheit ergibt sich einmal eine kleinere Defektanfälligkeit und zum anderen können nunmehr die Referenzspannungszellen auf der freien Siliciumfläche des Chips in der Peripherie untergebracht werden, woraus sich nochmals eine Einsparung an effektiver Chipfläche ergibt.

Die Erfindung wird nun anhand eines in der Zeichnung dargestellten Ausführungsbeispiels beschrieben. Es bedeutet

Fig. 1 ein Prinzipschaltbild eines Speichers mit Referenzspeicherzellen;

Fig. 2 die Draufsicht auf eine vollständige MTL-Speicherzelle;

Fig. 2A ein leitender Eingangs-/Ausgangs-PNP-Transistor;

Fig. 3 die Draufsicht auf eine Gestaltung von äquivalenten Referenzspannungsspeicherzellen in Form von Streifen von P-Diffusionen;

Fig. 3A ein Schnitt durch die Referenzspeicherzellen gemäß Fig. 3;

Fig. 4 eine Darstellung der Größenverhältnisse und der Anordnung der äquivalenten Referenzzellen sowie der eigentlichen Speicherzellen auf einem Halbleiterchip und

Fig. 5 ein Prinzipschaltbild zur Darstellung der Sperrschichtkapazitäten zwischen dem P-Streifen und dem Subkollektor für eine bestimmte Anzahl äquivalenter Referenzspeicherzellen.

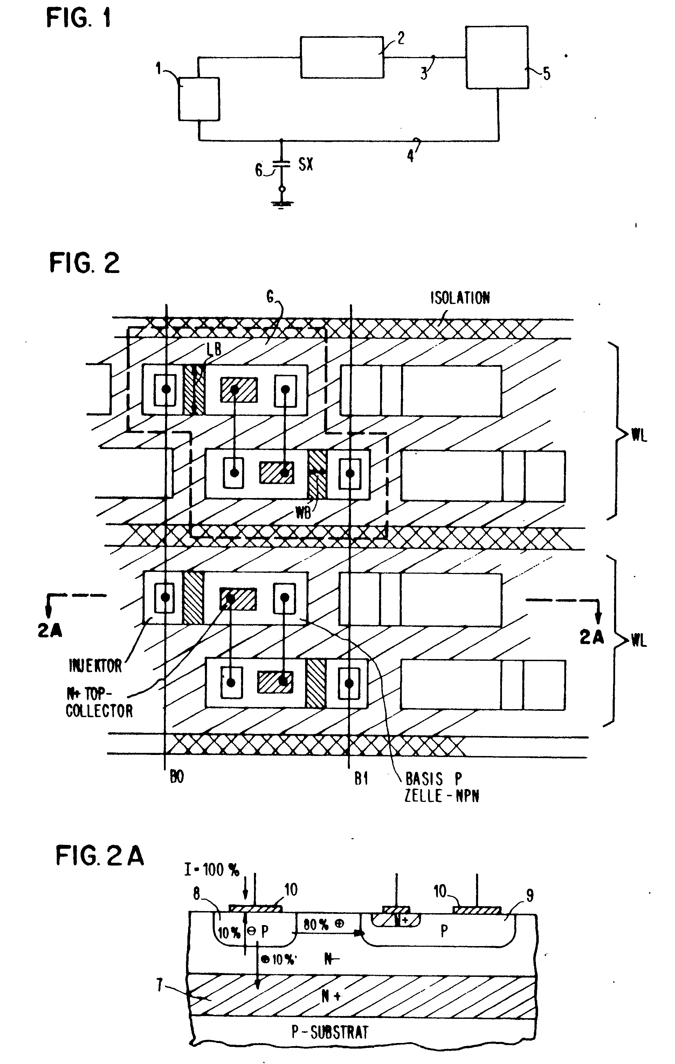

Das in Fig. 1 dargestellte Prinzipschaltbild des MTL-Speichers mit Referenzspannungsspeicherzellen zeigt links den eigentlichen Referenzspannungsgenerator, der in der beschriebenen bekannten Anordnung aus ca. 500 vollständigen Referenzspeicherzellen für ein 16 k Speicherchip besteht. Dieser Referenzspannungsgenerator 1 ist einmal über einen Referenzverstärker 2 und eine Bitreferenzleitung 3 und zum anderen über eine Wortreferenzleitung 4 mit dem eigentlichen Speicherzellenfeld 5 verbunden. Außerdem ist in der Fig. 1 schematisch die Kapazität 6 vom Subkollektor zum Substrat eingezeichnet, die in dem Ersatzschaltbild nach Fig. 1 einmal mit Masse und zum anderen mit der Wortreferenzleitung 4 verbunden ist.

Das eigentliche Informationsspeicherzellenfeld 5 enthält in diesem Ausführungsbeispiel MTL-Speicherzellen, wie sie in Fig. 2 dargestellt sind und nachfolgend kurz beschrieben werden. In der Fig. 2 sind zwei solche MTL-Speicherzellen dargestellt, die durch Isolationsstreifen voneinander getrennt sind.

Innerhalb einer Zelle ist im stabilen Zustand jeweils ein Zelltransistor gesperrt und der andere ist leitend. Für den Lateralen Eingangs-/Ausgangs-PNP-Transistor bedeutet dies, daß einer im aktiven, der andere im Sättigungsbereich betrieben wird. Ein Eingangs-/Ausgangs-PNP-Transistor hat für die Richtung vom Injektor nach der Basis des Zelltransistors ein $\alpha$ F von ungefähr 0,8 und in umgekehrter Richtung von der Basis des Zelltransistors nach dem Injektor ein $\alpha$ R von ungefähr 0,7. Dies wird durch die größere Fläche der P-Diffusion der Zelltransistorbasis gegenüber der Injektorfläche verursacht. In Fig. 2A ist ein leitender Eingangs-/Ausgangs-PNP-Transistor oder eine Halbzelle dargestellt. Oberhalb des Subkollektors 7 sind der Injektor 8 und der Kollektor 9 des PNP-Ausgangs-Transistors angeordnet. Der linke Kontakt 10 auf dem Injektor ist mit dem Eingang für den Strom I und der rechte Kontakt 10 ist auf der Basis 9 des NPN-Zell-Transistors angeordnet. Der rechte Kontakt 10 ist mit dem Kollektor des NPN-Transistors der Nachbar-Halbzelle verbunden. Hier fließt von dem Ruhezustandsstrom, der dem Injektor zugeführt wird, ca. 80% in lateraler Richtung über die Basiszone des PNP-Transistors und nur etwa jeweils 10% des Stromes werden am Kontakt und im Subkollektor rekombinieren. Die Pfeile mit dem Ladungsträgerzeichen bedeuten die Richtung der Ladungsträgerbewegung.

Ähnliches gilt auch für den gesättigten Eingangs-/Ausgangs-PNP-Transistor, nur muß dann der vom Zellbasisgebiet injizierte und vom Injektor kollektierte Strom als zugeführter Strom gerechnet werden.

Aus den gezeigten Stromverhältnissen geht hervor, daß die Verhältnisse in der lateralen Basis genau nachzubilden sind, die Flächenverhältnisse von Injektor und Zelltransistor-Basis tragen nur als Effekt zweiter Ordnung bei. Außerdem steht von der Zellhöhe etwa die Hälfte als Injektorkantenlänge zur Verfügung.

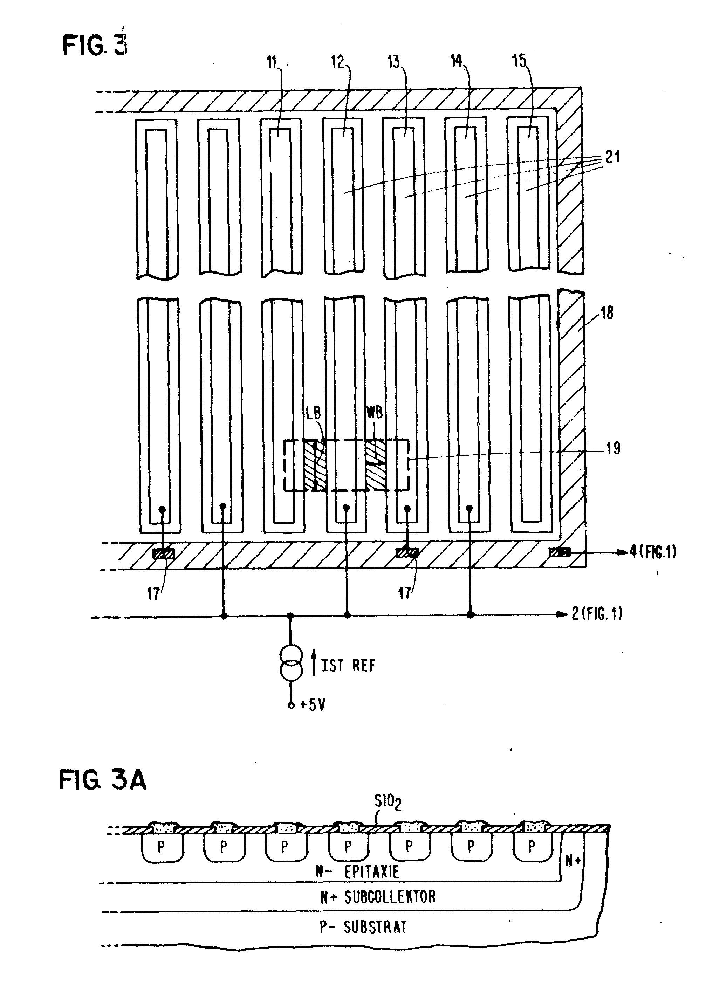

Die Referenzzellen des Referenzspannungsgenerators 1 in Fig. 1 sind keine echten Speicherzellen bzw. Referenzzellen sondern äquivalente Schaltungen. Eine derartige äquivalente Schaltung ist in den Fig. 3 und 3A, die ein Schnittbild durch das Lay-Out zeigt, dargestellt.

Aus der Fig. 3 geht hervor, daß innerhalb einer N-Wanne 18 z. B. sieben einzelne P-Streifen über einem Subkollektorgebiet angeordnet sind. Die N-Wanne 18 kann auch von einem Oxid- oder N+-Ring begrenzt werden.

Dabei bildet der Streifen 12 die parallel geschalteten Injektoren einer MTL-Speicherzelle nach. Durch die direkte Aneinanderreihung der Injektoren wird die Fläche für den Isolationsring eingespart. Führt man dem Injektorstreifen 12 Strom zu, so injiziert er an seinen Kanten einen Löcherstrom. Der Injektorstreifen 12 besteht wie jeder der anderen Streifen 11, 13 bis 15 aus einer Basisdiffusion auf der ein P-Kontaktstreifen 21 liegt.

Im nachfolgenden soll nun die rechte Kante des Injektorstreifens 12 betrachtet werden. Hier ist zu sehen, daß der injizierte Strom vom Kollektorstreifen 13 kollektiert wird und über einen Kontakt 17 zum Isolationsring 18 und von da aus zur Wortreferenzleitung 4 abgeführt wird. Die PNP-Struktur der beiden Streifen 12 und 13 bildet den leitenden Eingangs-/Ausgangs-PNP-Transistor nach. Betrachtet man nun die linke Kante des Injektorstreifens 12, so fließt der an der linken Kante injizierte Strom zu dem floatenden P-Streifen 11, wird dort kollektiert und ein Teil des Stroms wird wieder zurückinjiziert und vom Injektionsstreifen 12 kollektiert. Die PNP-Struktur der Streifen 12 und 11 bildet den gesättigten Eingangs-/Ausgangs-PNP-Transistor einer Speicherzelle nach.

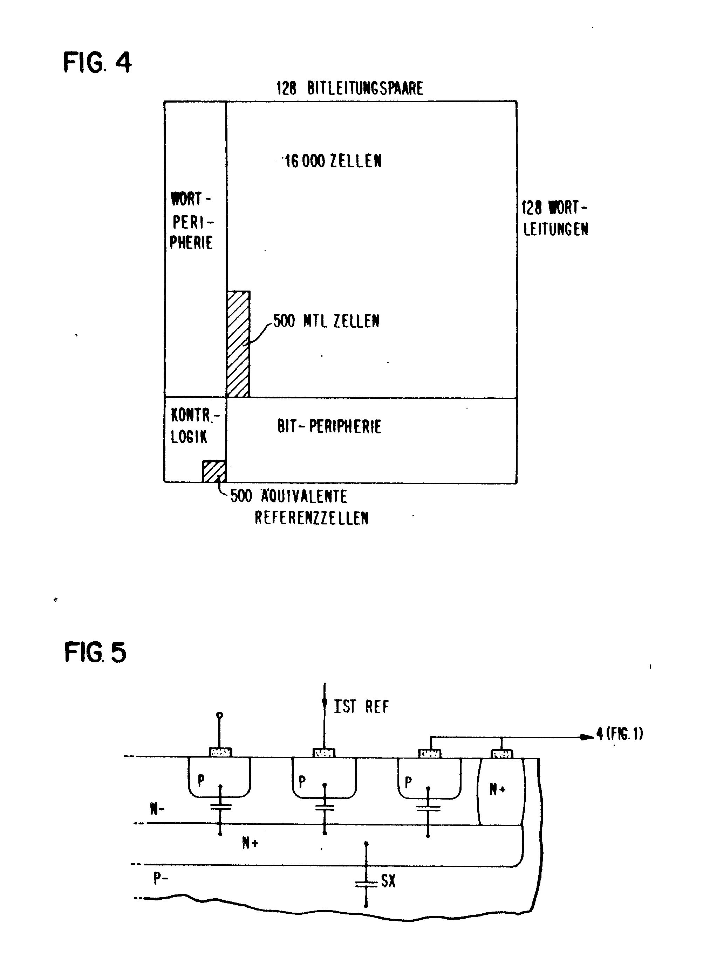

Symmetrisch zu dem Streifen 13 werden die Streifen 11 und 12 als Streifen 14 und 15 wiederholt, womit einmal die Fläche eines weiteren dem Streifen 13 entsprechenden Streifens eingespart wird. Die eingerahmte Fläche 19 in der Fig. 3 stellt das Äquivalent zu einer vollständigen MTL-Speicherzelle dar, wie zwei davon in Fig. 2 dargestellt sind. Durch die doppelte Ausnützung der P-Streifen (nämlich der rechten und der linken Kante) und durch die Einsparung des Isolationsringes mit seiner Ausdiffusion hat die Nachbildungsstruktur nur ca. $1/4$ der Höhe einer MTL-Speicherzelle. Auf dem Original Lay-Out muß wegen der zwei benachbarten Bitleitungen der Zellabstand gegenüber dem schematischen Lay-Out nach Fig. 2 etwa vergrößert werden, so daß dadurch die äquivalente Referenzzelle ca. $1/5$ der Fläche einer MTL-Speicherzelle einnimmt. Die Größenverhältnisse der Referenzspeicherzellen und der Informationsspeicherzellen sowie der Peripherieschaltkreise auf einem Chip sind schematisch aus der Fig. 4 zu ersehen. Aus dieser Darstellung ist auch ganz klar zu ersehen, daß die 500 äquivalenten Referenzzellen im unteren linken Teil des Chips nur bereits vorhandenen, sonst nicht genutzten Platz belegen. Im Vergleich hierzu sind 500 MTL-Speicherzellen auf der eigentlichen Speicherfläche gekennzeichnet. In dem hier gezeigten Beispiel für 16 K Speicherzellen können somit ohne Änderung der Technologie und des Lay-Outs der eigentlichen Speicherzellen mindestens 500 Speicherzellen mehr auf die gleiche Siliciumfläche aufgebracht werden. Sind aufgrund der Auslegung des Speicherchips eine größere Anzahl von Referenzspeicherzellen erforderlich, dann ist die Einsparung an effektiver Siliciumfläche noch größer.

In Fig. 5 ist ein Querschnitt durch das Lay-Out mit einem Ersatzschaltbild kombiniert worden, um die einzelnen Kapazitäten und deren Wirkung erkennen zu können. Wie aus der Fig. 5 zu sehen ist, ist die Sperrschichtkapazität zwischen dem Subkollektor für 500 äquivalente Referenzspeicherzellen von Vorteil, da sie zur Stabilisierung der Referenzspannung beiträgt. Die Kapazität vom Subkollektor zum Substrat wird über die Wortreferenzleitung allen Wortleitungskapazitäten parallel geschaltet. Diese Kapazität wird nicht umgeladen und erfordert somit auch keine elektrische Leistung. Durch diese Nachbildung einer Referenzspeicherzelle wird eine Zellreferenzspannung mit hoher Genauigkeit erreicht, wobei die Nachbildung nur etwa $1/5$ der Fläche einer Originalspeicherzelle benötigt. Außerdem liefern die Nachbildungen der Referenzspeicherzellen auch deshalb die richtige Zellreferenzspannung, weil die globalen Prozeßparameter für ein Chip einheitlich sind und auf einem Chip auch eine einheitliche Temperatur angenommen werden kann.

## Patentansprüche

1. Speicherzellennachbildung zur Referenzspannungserzeugung für Halbleiterspeicher in vorzugsweise MTL-Technik auf einem gemeinsamen Halbleiterchip, das eine N-Wanne (18) mit n darin liegenden P-Diffusionsstreifen (11 bis 15) aufweist, dadurch gekennzeichnet, daß ein P-Diffusionsstreifen als Kollektorstreifen (13) metallisch mit einem festen Potential zur Verhinderung der Rückinjektion vom Kollektorstreifen (13) verbunden ist, daß zwei diesem Kollektorstreifen (13) benachbarte P-Streifen (12 und 14) als Injektorstreifen dienen und mit einer Quelle, die einen Strom gemäß dem Ruhezustandsstrom der Zellen liefert, und mit dem Referenzverstärker (2) verbunden sind, und daß die beiden äußeren P-Diffusionsstreifen (11 und 15) als floatende Kollektoren dienen, währenddem die N-Wanne (18) mit der Wortreferenzleitung (4) des Informationsspeicherzellenfeldes (5) verbunden ist.

2. Speicherzellennachbildung nach Anspruch 1, dadurch gekennzeichnet, daß die mit der Stromquelle verbundenen Injektorstreifen (12 und 14) an ihren beiden Kanten einen Löcherstrom injizieren, so daß der injizierte Strom vom Kollektorstreifen (13) kollektiert und über einen Kontakt (17) zur N-Wanne (18) und von da zur Wortreferenzleitung (4) abgeführt wird, während die PNP-Struktur der beiden benachbarten Streifen einen leitenden Eingangs-/Ausgangs-PNP-Transistor nachbildet.

3. Speicherzellennachbildung nach den Ansprüchen 1 und 2, dadurch gekennzeichnet, daß die Breite des floatenden Kollektorstreifens (11, 15) gleich oder kleiner der Breite des Kollektorstreifens der MTL-Speicherzelle (nach Fig. 2) ist.

4. Speicherzellennachbildung nach den Ansprüchen 1 bis 3, dadurch gekennzeichnet, daß die N-Wanne (18) mit einem Oxidring oder einem N+-Ring begrenzt ist.

## Claims

1. Storage cell simulation for the reference voltage generation for semiconductor storages preferably in MTL technique on a common semiconductor chip, characterized in that a P-diffusion strip is metallically connected as a collector strip (13) to a fixed potential to prevent the re-injection from the collector strip (13), that the two P-strips (12 and 14) adjacent to this collector strip (13) are connected to a source supplying a current in accordance with the standby current of the cells and to the reference amplifier (2), and that the two outer P-diffusion strips (11 and 15) serve as floating collectors, whereas the N-trough (18) is connected to the word reference line (4) of the data cell array (5).

2. Storage cell simulation as claimed in claim 1, characterized in that the injector strips (12 and 14) connected to the current source inject at their two edges a hole current so that the injected current is received by the collector strip (13), and directed via a contact (17) to the N-trough (18) and from there to word reference line (4), whereas the PNP structure of the two adjacent strips simulate a conductive input/output PNP transistor.

3. Storage cell simulation as claimed in claims 1 and 2, characterized in that the width of the floating collector (11, 15) is equal to, or smaller than the width of the collector strip of the MTL storage cell (according to fig. 2).

4. Storage cell simulation as claimed in any one of claims 1 to 3, characterized in that the N-trough (18) is limited by an oxide ring or by an N + -ring.

## Revendications

1. Simulation de cellule à mémoire afin de générer une tension de référence pour une mémoire à semiconducteurs de préférence en technologie MTL dans une microplaquette à semiconducteurs commune qui comporte une poche de type N (18) comprenant n bandes de diffusion de type P (11 à 15), caractérisée en ce qu'une bande de diffusion de type P est connectée en tant que bande de collecteur (13) par un moyen métallique à un potentiel élevé afin d'empecher une réinjection à partir de ladite bande de collecteur (13), que deux bandes de type P (12 et 14) contigues à ladite bande de collecteur (13) sont utilisées comme bandes d'injection et sont connectées d'une part à une source qui délivre un courant selon le courant d'attente des cellules et d'autre part à un amplificateur de référence (2), et que les deux bandes de diffusion de type P marginales (11 et 15) sont utilisées comme bandes de collecteur flottant, tandis que la poche de type N (18) est connectée à la ligne de référence de mot (4) de la matrice de mémorisation de l'information (5).

2. Simulation de cellules de mémoire selon la revendication 1, caractérisée en ce que les bandes d'injection (12 et 14) connectées à ladite source de courant injectent vers leurs deux flancs un courant de trous de sorte que le courant injecté est collecté par la bande de collecteur (13) pour etre transmis à travers un contact (17) à ladite poche de type N (18) puis de cette dernière à ladite ligne de référence de mot (4), tandis que la structure PNP des deux bandes contigues simule un transistor entrée-sortie PNP à l'état conducteur.

3. Simulation de cellule à mémoire selon les revendications 1 et 2, caractérisée en ce que la largeur de la bande de collecteur flottant (11, 15) est égale ou inférieure à la largeur de la bande de collecteur de la cellule de mémoire MTL (voir la fig. 2).

4. Simulation de cellule à mémoire selon les revendications 1 à 3, caractérisée en ce que la poche N (8) est limitée par un anneau en oxyde ou de type N +.

## FIG. 1

## FIG. 2

ISOLATION

LB

WL

WB

2A

INJEKTOR

N+ TOP-
COLLECTOR

2A

WL

B0

B1

BASIS P
ZELLE - NPN

## FIG. 2A

I • 100 %

8     10

10 %  ⊖ P    80 % ⊕     N+     P     10     9

⊕ 10 %     N-

7     N +

P - SUBSTRAT

7

## FIG. 3

## FIG. 3A

## FIG. 4

128 BITLEITUNGSPAARE

16 000 ZELLEN

WORT-
PERI-
PHERIE

128 WORT-
LEITUNGEN

500 MTL ZELLEN

KONTR.-
LOGIK

BIT-PERIPHERIE

500 ÄQUIVALENTE
REFERENZZELLEN

## FIG. 5

IST REF

4 (FIG.1)

P          P          P          N+

N-

N+

P-          SX